# EUROPEAN PATENT APPLICATION

(11) **EP 4 145 549 A1**
(43) Date of publication of application: **08.03.2023**
(21) Application number: 21797391.6
(22) Date of filing: 29.03.2021
(51) Int. Cl.: H01L 51/42, H01L 27/146

(54) **PHOTOELECTRIC CONVERSION ELEMENT AND IMAGING DEVICE**

(30) Priority: 27.04.2020 JP 2020078444
(71) Applicant: Panasonic Intellectual Property Management Co., Ltd., Osaka-shi, Osaka 540-6207 (JP)
(72) Inventor: IZUCHI Masumi, Osaka-shi Osaka (JP); IIJIMA Hiroaki, Osaka-shi Osaka (JP); HIRADE Masaya, Osaka-shi Osaka (JP); KISHIMOTO Yuko, Osaka-shi Osaka (JP)
(74) Representative: Grünecker Patent- und Rechtsanwälte PartG mbB
(86) International application number: PCT/JP2021/013173
(87) International publication number: WO 2021/220691

(57) **Abstract**

The photoelectric conversion element according to an aspect of the present disclosure includes a first electrode, a second electrode, a photoelectric conversion layer positioned between the first electrode and the second electrode and including a donor semiconductor material and an acceptor semiconductor material, and a first charge blocking layer positioned between the first electrode and the photoelectric conversion layer. The first charge blocking layer includes a first material and a second material having an energy band gap narrower than that of the first material. The electron affinity of the first material is lower than that of the second material, and the ionization potential of the first material is higher than that of the second material.

## Description

### Technical Field

The present disclosure relates to a photoelectric conversion element and an imaging apparatus.

### Background Art

A photoelectric conversion element using a semiconductor material thin-film takes out the charge generated by light as an electric signal and thereby can be used as an optical sensor of a solid-state image sensor or the like.

However, such a photoelectric conversion element using a semiconductor material thin-film as a photoelectric conversion layer has a problem that application of a voltage from the outside causes injection of a charge from an electrode into the photoelectric conversion layer to increase the current flowing in a dark state (i.e., dark current) and reduce the S/N (signal noise) ratio.

In order to solve this problem, PTL 1 and PTL 2 disclose a method for suppressing a dark current by providing a charge blocking layer between an electrode and the photoelectric conversion layer of a photoelectric conversion element. As the method for suppressing a dark current, for example, a charge blocking layer is provided between an electrode and a photoelectric conversion layer to define the energy levels of the electrode adjacent to the charge blocking layer and the photoelectric conversion layer and to block the charge injection from the electrode.

### Citation List

### Patent Literature

PTL 1: Japanese Patent No. 4677314
PTL 2: Japanese Patent No. 5969843

### Summary of Invention

### Technical Problem

In the above-mentioned known technologies, suppression of charge injection from an electrode is insufficient in some cases, and it is desired to decrease the dark current for improving the S/N ratio of the photoelectric conversion element.

Accordingly, it is an object of the present disclosure to provide a photoelectric conversion element and an imaging apparatus that can each decrease the dark current. Solution to Problem

The photoelectric conversion element according to an aspect of the present disclosure includes a first electrode, a second electrode, a photoelectric conversion layer positioned between the first electrode and the second electrode and including a donor semiconductor material and an acceptor semiconductor material, and a first charge blocking layer positioned between the first electrode and the photoelectric conversion layer. The first charge blocking layer includes a first material and a second material having an energy band gap narrower than an energy band gap of the first material. An electron affinity of the first material is lower than an electron affinity of the second material. An ionization potential of the first material is higher than an ionization potential of the second material.

In addition, the imaging apparatus according to an aspect of the present disclosure includes a substrate, a charge detection circuit provided to the substrate, a photoelectric conversion portion provided on the substrate, and a pixel including a charge storage node electrically connected to the charge detection circuit and the photoelectric conversion portion, and the photoelectric conversion portion includes the above-described photoelectric conversion element.

### Advantageous Effects of Invention

According to the present disclosure, it is possible to provide a photoelectric conversion element and an imaging apparatus that can each decrease the dark current. Brief Description of Drawings

[Fig. 1] Fig. 1 is a schematic cross-sectional view illustrating a configuration of a photoelectric conversion element according to an embodiment.
[Fig. 2] Fig. 2 is an exemplary energy band diagram of a photoelectric conversion element according to an embodiment.
[Fig. 3] Fig. 3 is a diagram showing an example of the circuit configuration of an imaging apparatus according to an embodiment.
[Fig. 4] Fig. 4 is a schematic cross-sectional view illustrating an example of a pixel device structure in an imaging apparatus according to an embodiment.
[Fig. 5] Fig. 5 is a timing chart for explaining a global shutter operation in an imaging apparatus according to an embodiment.
[Fig. 6] Fig. 6 is a diagram illustrating a schematic configuration of the photoelectric conversion elements in Examples 1 to 3.
[Fig. 7] Fig. 7 is a diagram illustrating a schematic configuration of the photoelectric conversion element in Comparative Example 1.
[Fig. 8] Fig. 8 is a diagram illustrating a schematic configuration of the photoelectric conversion element in Comparative Example 2.

### Description of Embodiments

### (Underlying Knowledge Forming Basis of an aspect of the Present Disclosure)

When a charge blocking layer is provided to a photoelectric conversion element to suppress charge injection into a photoelectric conversion layer, the dark current is increased by charge injection via, for example, an intermediate level present in the charge blocking layer in some cases. For example, the intermediate level of a charge blocking layer is generated by, for example, aggregation of the material constituting the charge blocking layer. However, in the known technologies of PTL 1 and PTL 2, no countermeasure for such charge injection via the intermediate level or the like of the charge blocking layer is described, and suppression of the dark current is insufficient in some cases.

Thus, the present inventors found that when the dark current is decreased by a charge blocking layer, the dark current can be decreased by suppressing the charge injection via the intermediate level present in the charge blocking layer.

Accordingly, the present disclosure provides a photoelectric conversion element and an imaging apparatus that can each decrease the dark current by suppressing the charge injection via the intermediate level present in the charge blocking layer.

### (Outline of the present disclosure)

The outline of one aspect of the present disclosure is as follows.

The photoelectric conversion element according to an aspect of the present disclosure includes a first electrode, a second electrode, a photoelectric conversion layer positioned between the first electrode and the second electrode and including a donor semiconductor material and an acceptor semiconductor material, and a first charge blocking layer positioned between the first electrode and the photoelectric conversion layer. The first charge blocking layer includes a first material and a second material having an energy band gap narrower than that of the first material. The electron affinity of the first material is lower than that of the second material, and the ionization potential of the first material is higher than that of the second material.

Thus, the first charge blocking layer includes a first material with a relatively broad energy band gap and a second material with a relatively narrow energy band gap, the interaction between electron clouds of the materials of the first charge blocking layer is thereby reduced, and the formation of an intermediate level can be prevented. As a result, charge injection from a first electrode into a photoelectric conversion layer via the intermediate level can be suppressed. Accordingly, the photoelectric conversion element according to the present aspect can decrease the dark current.

In addition, for example, the electron affinity of the second material may be lower than that of the acceptor semiconductor material.

Consequently, the migration barrier for electrons from the first electrode to the photoelectric conversion layer becomes large to effectively suppress the injection of electrons from the first electrode to the photoelectric conversion layer.

In addition, for example, the ionization potential of the first material may be higher than that of the donor semiconductor material.

Consequently, the migration barrier for holes from the first electrode to the photoelectric conversion layer becomes large to effectively suppress the injection of holes from the first electrode to the photoelectric conversion layer.

In addition, for example, the ionization potential of the second material may be equal to or higher than the ionization potential of the donor semiconductor material.

Consequently, the migration barrier for holes from the first electrode to the photoelectric conversion layer becomes large to effectively suppress the injection of holes from the first electrode to the photoelectric conversion layer.

In addition, for example, the energy band gap of the first material may be 3.0 eV or more, and the energy band gap of the second material may be 2.0 eV or less.

The dark current can be effectively decreased by using a first material and a second material having such energy band gaps.

In addition, for example, the difference between the energy band gap of the first material and the energy band gap of the second material may be 1.0 eV or more and 3.0 eV or less.

The dark current can be effectively decreased by using a first material and a second material having energy band gaps with such a difference.

In addition, for example, in the first charge blocking layer, the weight of the first material may be 30% or more and 70% or less of the total weight of the first material and the second material.

The dark current can be effectively decreased by constituting the first charge blocking layer with such a ratio of the first material and the second material.

In addition, for example, the donor semiconductor material may be a donor organic semiconductor material, and the acceptor semiconductor material may be an acceptor organic semiconductor material.

Consequently, a thin film functioning as the photoelectric conversion layer can be easily formed.

In addition, for example, the photoelectric conversion element may further include a second charge blocking layer positioned between the second electrode and the photoelectric conversion layer.

Consequently, charge injection from both the first electrode and the second electrode is suppressed, and the dark current can be further effectively decreased.

In addition, for example, the electron affinity of the second charge blocking layer may be lower than that of the acceptor semiconductor material, and the ionization potential of the second charge blocking layer may be higher than that of the donor semiconductor material.

Consequently, the migration barrier for electrons and holes from the second electrode to the photoelectric conversion layer becomes large, and injection of electrons and holes from the second electrode to the photoelectric conversion layer can be effectively suppressed.

In addition, the imaging apparatus according to an aspect of the present disclosure includes a substrate, and a pixel including a charge detection circuit provided to the substrate, a photoelectric conversion portion provided on the substrate, and a charge storage node electrically connected to the charge detection circuit and the photoelectric conversion portion. The photoelectric conversion portion includes the photoelectric conversion element.

Consequently, since the imaging apparatus according to the present aspect includes a photoelectric conversion portion including the above-described photoelectric conversion element, the dark current can be decreased. Accordingly, in the imaging apparatus according to the present aspect, the S/N ratio is improved, and a good imaging property can be obtained.

In addition, for example, the imaging apparatus may further include a voltage supply circuit that is electrically connected to the first electrode or the second electrode and giving a potential difference between the first electrode and the second electrode, and the voltage supply circuit may supply a first voltage during a first period and a second voltage different from the first voltage during a second period to the first electrode or the second electrode connected to the voltage supply circuit.

Consequently, the timing of photoelectric conversion and the timing of performing read-out can be separated by setting the first voltage and the second voltage according to the characteristics of the photoelectric conversion layer.

In addition, for example, the photoelectric conversion efficiency of the pixel during the first period may be different from the photoelectric conversion efficiency of the pixel during the second period.

Consequently, during the first period and the second period, the first voltage and the second voltage are selected in such a manner that the change in current density differs depending on the amount of light incident on the photoelectric conversion layer. For example, the dark current can be decreased by recombination of holes and electrons in the photoelectric conversion layer during the period during which the change in current density decreases depending on the amount of light.

Embodiments will now be described with reference to the drawings.

Incidentally, the embodiments described below are all inclusive or specific examples. Hereinafter, the numerical values, shapes, components, arrangement positions and connection forms of the components, steps, order of the steps, etc. shown in the following embodiments are examples, and are not intended to limit the present disclosure. Of the components in the following embodiments, components that are not described in the independent claims showing the highest-order concept are described as optional components. In addition, each drawing is not necessarily exactly illustrated. In each drawing, substantially the same configurations are designated by the same reference numeral, and redundant explanation may be omitted or simplified.

### (Embodiment)

A photoelectric conversion element and an imaging apparatus according to the present embodiment will now be described.

### [Photoelectric conversion element]

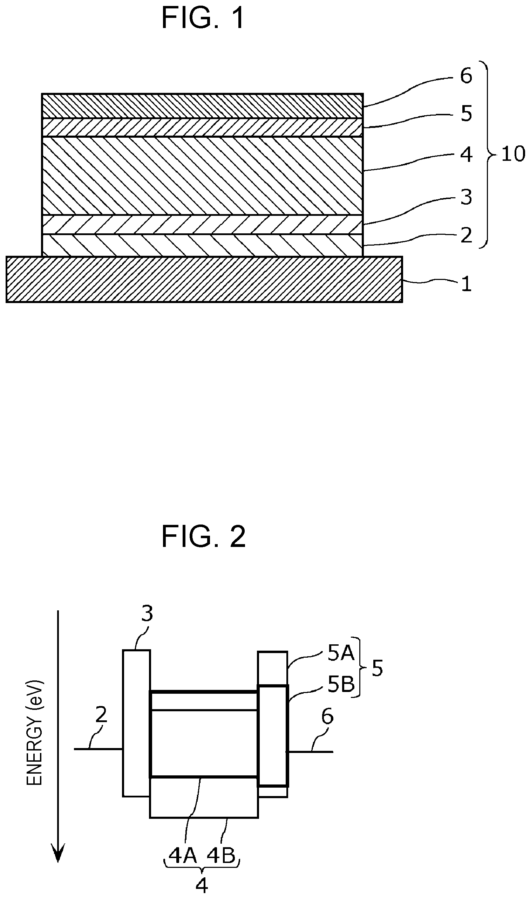

First, a photoelectric conversion element according to the present embodiment will be described using Figs. 1 and 2. The photoelectric conversion element according to the present embodiment is, for example, a photoelectric conversion element of a charge read-out system. Fig. 1 is a schematic cross-sectional view illustrating a configuration of a photoelectric conversion element 10 according to the present embodiment.

As shown in Fig. 1, the photoelectric conversion element 10 is supported by a support substrate 1 and includes a pair of electrodes, an upper electrode 6 and a lower electrode 2; a photoelectric conversion layer 4 positioned between the pair of electrodes; a first charge blocking layer 5 positioned between the upper electrode 6, which is one of the pair of electrodes, and the photoelectric conversion layer 4; and a second charge blocking layer 3 positioned between the lower electrode 2, which is the other of the pair of electrodes, and the photoelectric conversion layer 4. Incidentally, the photoelectric conversion element 10 may have a structure in which the second charge blocking layer 3 is not included and the lower electrode 2, the photoelectric conversion layer 4, the first charge blocking layer, and the upper electrode 6 are stacked in this order. In the present embodiment, the upper electrode 6 corresponds to the first electrode in the present disclosure, and the lower electrode 2 corresponds to the second electrode in the present disclosure.

Each component of the photoelectric conversion element 10 according to the present embodiment will now be described.

The support substrate 1 may be a substrate that is used for supporting a general photoelectric conversion element and may be, for example, a glass substrate, a quartz substrate, a semiconductor substrate, or a plastic substrate.

The lower electrode 2 is formed from, for example, a metal, a metal nitride, a metal oxide, or a polysilicon imparted with conductivity. Examples of the metal include aluminum, copper, titanium, and tungsten. Examples of the method for imparting conductivity to polysilicon include doping with an impurity.

The upper electrode 6 is a transparent electrode formed from, for example, a transparent conductive material. Examples of the material of the upper electrode 6 include TCO (transparent conducting oxide), ITO (indium tin oxide), IZO (indium zinc oxide), AZO (aluminum-doped zinc oxide), FTO (fluorine-doped tin oxide), SnO₂, and TiO₂. Incidentally, the upper electrode 6 may be appropriately produced from metal materials, such as TCO, aluminum (Al), and gold (Au), alone or in combination according to a desired transmittance.

Incidentally, the materials of the lower electrode 2 and the upper electrode 6 are not limited to the above-described conductive materials, and other materials may be used. For example, the lower electrode 2 may be a transparent electrode.

The lower electrode 2 and the upper electrode 6 are produced by various methods according to the materials to be used. For example, when ITO is used, a chemical reaction method, such as an electron beam method, a sputtering method, a resistance heating vapor deposition method, and a sol-gel method, or a method, such as application of an indium tin oxide dispersion, may be used. In this case, in the production of the lower electrode 2 and the upper electrode 6, after the formation of an ITO film, for example, UV-ozone treatment or plasma treatment may be further performed.

The photoelectric conversion layer 4 includes a donor semiconductor material and an acceptor semiconductor material. The photoelectric conversion layer 4 is produced using, for example, an organic semiconductor material. As the method for producing the photoelectric conversion layer 4, for example, a wet method, such as application by spin coating or the like, or a dry method, such as a vacuum vapor deposition method, can be used. The vacuum vapor deposition method is a method of evaporating the material of a layer by heating in vacuum and depositing the material on a substrate. Alternatively, the photoelectric conversion layer 4 is, for example, a mixture film of a bulk-heterostructure including a donor organic semiconductor material and an acceptor organic semiconductor material. The photoelectric conversion layer 4 is easily formed as a thin film by including a donor organic semiconductor material and an acceptor organic semiconductor material. Hereinafter, the donor organic semiconductor material and the acceptor organic semiconductor material are specifically exemplified.

Examples of the donor organic semiconductor material include a metal complex including, as a ligand, a triarylamine compound, a benzidine compound, a pyrazoline compound, a styrylamine compound, a hydrazone compound, a triphenylmethane compound, a carbazole compound, a polysilane compound, a thiophene compound, a phthalocyanine compound, a naphthalocyanine compound, a subphthalocyanine compound, a cyanine compound, a merocyanine compound, an oxonol compound, a polyamine compound, an indole compound, a pyrrole compound, a pyrazole compound, a polyarylene compound, a condensed aromatic carbocyclic compound (e.g., a naphthalene derivative, an anthracene derivative, a phenanthrene derivative, a tetracene derivative, a pyrene derivative, a perylene derivative, and a fluoranthene derivative), or a nitrogen-containing heterocyclic compound.

Examples of the acceptor organic semiconductor material include a metal complex including, as a ligand, a fullerene (e.g., C60 fullerene and C70 fullerene), a fullerene derivative (e.g., PCBM (phenyl-C61-butyric acid methyl ester) and ICBA (indene-C60 bis-adduct)), a condensed aromatic carbocyclic compound (e.g., a naphthalene derivative, an anthracene derivative, a phenanthrene derivative, a tetracene derivative, a pyrene derivative, a perylene derivative, and a fluoranthene derivative), a 5- to 7-membered heterocyclic compound containing a nitrogen atom, an oxygen atom, or a sulfur atom (e.g., pyridine, pyrazine, pyrimidine, pyridazine, triazine, quinoline, quinoxaline, quinazoline, phthalazine, cinnoline, isoquinoline, pteridine, acridine, phenazine, phenanthroline, tetrazole, pyrazole, imidazole, thiazole, oxazole, indazole, benzimidazole, benzodriazole, benzoxazole, benzothiazole, carbazole, purine, triazolopyridazine, triazolopyrimidine, tetrazaindene, oxadiazole, imidazopyridine, pyrrolidine, pyrrolopyridine, thiadiazolopyridine, dibenzazepine, and tribenzazepine), a polyarylene compound, a fluorene compound, a cyclopentadiene compound, a silyl compound, or a nitrogen-containing heterocyclic compound.

The donor organic semiconductor material and the acceptor organic semiconductor material are not limited to the above-mentioned examples. Low molecular weight organic compounds and high molecular weight organic compounds that are semiconductor materials of organic compounds capable of being formed into a photoelectric conversion layer by either a dry or wet method may be used as a donor organic semiconductor material and an acceptor organic semiconductor material constituting the photoelectric conversion layer 4.

The photoelectric conversion layer 4 mayinclude a semiconductor material other than the above as a donor semiconductor material or an acceptor semiconductor material. The photoelectric conversion layer 4 may include, as a semiconductor material, for example, a silicon semiconductor, a compound semiconductor, a quantum dot, a perovskite material, a carbon nanotube, or a mixture of two or more thereof.

The photoelectric conversion element 10 according to the present embodiment includes a second charge blocking layer 3 positioned between the lower electrode 2 and the photoelectric conversion layer 4 and a first charge blocking layer 5 positioned between the upper electrode 6 and the photoelectric conversion layer 4. Charge injection from an electrode can be suppressed by providing the second charge blocking layer 3 and the first charge blocking layer 5, and the dark current can be decreased.

As the materials that are used in the second charge blocking layer 3 and the first charge blocking layer 5, semiconductor materials having energy bands described later are used. The second charge blocking layer 3 and the first charge blocking layer 5 are formed of, for example, an organic semiconductor material. The materials forming the second charge blocking layer 3 and the first charge blocking layer 5 are not limited to organic semiconductor materials, and may be an oxide semiconductor or a nitride semiconductor or may be a composite material thereof.

The first charge blocking layer 5 includes a first material and a second material having an energy band gap narrower than that of the first material. In the first charge blocking layer 5, the weight of the first material is, for example, 30% or more and 70% or less of the total weight of the first material and the second material. Incidentally, the first charge blocking layer 5 may include a material other than the first material and the second material.

Fig. 2 is an exemplary energy band diagram of the photoelectric conversion element 10 shown in Fig. 1. In Fig. 2, the energy band of each layer is shown by a rectangle.

The photoelectric conversion layer 4 generates a pair of an electron and a hole therein by irradiation with light. The generated pair of an electron and a hole is separated into an electron and a hole by an electric field applied to the photoelectric conversion layer 4. The electron and the hole each migrate to the lower electrode 2 side or the upper electrode 6 side according to the electric field. Here, the semiconductor material that supplies the electron of the pair of an electron and a hole generated by absorption of light to the other material is the donor semiconductor material, and the semiconductor material that receives the electron is the acceptor semiconductor material. The donor organic semiconductor material is an example of the donor semiconductor material, and the acceptor organic semiconductor material is an example of the acceptor semiconductor material. In the photoelectric conversion layer 4 irradiated with light, for example, the donor semiconductor material generates a pair of an electron and a hole and supplies the electron to the acceptor semiconductor material. When different two organic semiconductor materials are used, which is the donor semiconductor material and which is the acceptor semiconductor material are generally determined by the relative positions of energy levels of HOMO (highest-occupied-molecular-orbital) and LUMO (lowest-unoccupied-molecular-orbital) of each of the two organic semiconductor materials at the contact interface. In Fig. 2, the upper end of the rectangle showing an energy band is the energy level of LUMO, and the lower end is the energy level of HOMO.

As shown in Fig. 2, of the two organic semiconductor materials, the one with a lower electron affinity, the electron affinity being the energy difference between the vacuum level and the energy level of LUMO, becomes the donor organic semiconductor material 4A that is the donor semiconductor material, and the other with a higher electron affinity becomes the acceptor organic semiconductor material 4B that is the acceptor semiconductor material.

As shown in Fig. 2, the electron affinity of the second charge blocking layer 3 is, for example, lower than the electron affinity of the acceptor organic semiconductor material 4B of the photoelectric conversion layer 4. Consequently, the migration barrier for electrons from the lower electrode 2 to the photoelectric conversion layer 4 becomes large, and injection of electrons from the lower electrode 2 to the photoelectric conversion layer 4 can be effectively suppressed.

In addition, the ionization potential of the second charge blocking layer 3 is, for example, higher than the ionization potential of the donor organic semiconductor material 4A of the photoelectric conversion layer 4. Consequently, the migration barrier for holes from the lower electrode 2 to the photoelectric conversion layer 4 becomes large, and injection of holes from the lower electrode 2 to the photoelectric conversion layer 4 can be effectively suppressed.

The first charge blocking layer 5 includes a first material 5A with a relatively broad energy band gap and a second material 5B with a relatively narrow energy band gap in order to reduce the interaction between electron clouds of the materials of the first charge blocking layer 5 and to prevent the formation of an intermediate level. The electron affinity of the first material 5A in the first charge blocking layer 5 is lower than the electron affinity of the second material 5B in the first charge blocking layer 5. The ionization potential of the first material 5A in the first charge blocking layer 5 is higher than the ionization potential of the second material 5B in the first charge blocking layer 5. Thus, in the first charge blocking layer 5 including the first material 5A and the second material 5B, the interaction between electron clouds of the materials of the first charge blocking layer 5 is reduced, and the formation of an intermediate level can be prevented, compared to when the first charge blocking layer 5 is constituted of a single material, for example, the first material 5A only or the second material 5B only. Accordingly, regardless of whether a forward bias voltage or a reverse bias voltage described later is applied to the photoelectric conversion element 10, charge injection from the upper electrode 6 to the photoelectric conversion layer 4 via an intermediate level is suppressed. As a result, the dark current in the photoelectric conversion element 10 can be decreased. Incidentally, in the present specification, the following description is performed by the definition such that when a voltage higher than that of the lower electrode 2 is applied to the upper electrode 6, the voltage is of bias in the reverse direction, of so-called reverse bias, and when a voltage lower than that of the lower electrode 2 is applied to the upper electrode 6, the voltage is of bias in the forward direction, of so-called forward bias.

In addition, in the first charge blocking layer 5 including the first material 5A and the second material 5B, the signal charge generated in the photoelectric conversion layer 4 is unlikely to be prevented from migrating to an electrode, compared to when the first charge blocking layer 5 is constituted of only the first material 5A with a broad energy band gap. Accordingly, the dark current can be decreased while a reduction in the photoelectric conversion efficiency of the photoelectric conversion element 10 is suppressed.

The electron affinity of the second material 5B in the first charge blocking layer 5 is, for example, lower than the electron affinity of the acceptor organic semiconductor material 4B in the photoelectric conversion layer 4. Consequently, the migration barrier for electrons from the upper electrode 6 to the photoelectric conversion layer 4 becomes large, and injection of electrons from the upper electrode 6 to the photoelectric conversion layer 4 can be effectively suppressed.

In addition, the ionization potential of the first material 5A in the first charge blocking layer 5 is, for example, higher than the ionization potential of the donor organic semiconductor material 4A in the photoelectric conversion layer 4. Consequently, the migration barrier for holes from the upper electrode 6 to the photoelectric conversion layer 4 becomes large, and injection of holes from the upper electrode 6 to the photoelectric conversion layer 4 can be effectively suppressed.

In addition, the ionization potential of the second material 5B in the first charge blocking layer 5 is, for example, equal to or higher than the ionization potential of the donor organic semiconductor material 4A in the photoelectric conversion layer 4. Consequently, the migration barrier of holes from the upper electrode 6 to the photoelectric conversion layer 4 becomes large, and injection of holes from the upper electrode 6 to the photoelectric conversion layer 4 can be effectively suppressed.

For example, the energy band gap of the first material 5A is 3.0 eV or more, and the energy band gap of the second material 5B is 2.0 eV or less. For example, the difference between the energy band gap of the first material 5A and the energy band gap of the second material 5B is 1.0 eV or more and 3.0 eV or less. The difference between the energy band gap of the first material 5A and the energy band gap of the second material 5B may be 1.1 eV or more and 2.5 eV or less. Here, the energy band gap is the energy difference between a HOMO level and a LUMO level, in other words, the energy difference between an ionization potential and an electron affinity.

The large and small relationships between the energies of the above-mentioned materials are examples, and as long as that the electron affinity of the first material 5A is lower than that of the second material 5B and that the ionization potential of the first material 5A is higher than that of the second material 5B, the large and small relationships of other energies may be different from the above-mentioned examples.

As described above, the photoelectric conversion element 10 according to the present embodiment includes a pair of electrodes, a lower electrode 2 and an upper electrode 6; a photoelectric conversion layer 4 positioned between the pair of electrodes and made of a mixture film including a donor organic semiconductor material and an acceptor organic semiconductor material; and a first charge blocking layer 5 positioned between the upper electrode 6 and the photoelectric conversion layer 4. The first charge blocking layer 5 includes a first material and a second material having an energy band gap narrower than that of the first material. The electron affinity of the first material is lower than that of the second material, and the ionization potential of the first material is higher than that of the second material.

In the photoelectric conversion element 10 including such a first charge blocking layer 5, as described above, the formation of an intermediate level in the first charge blocking layer 5 is prevented, and the dark current can be decreased.

### [Imaging apparatus]

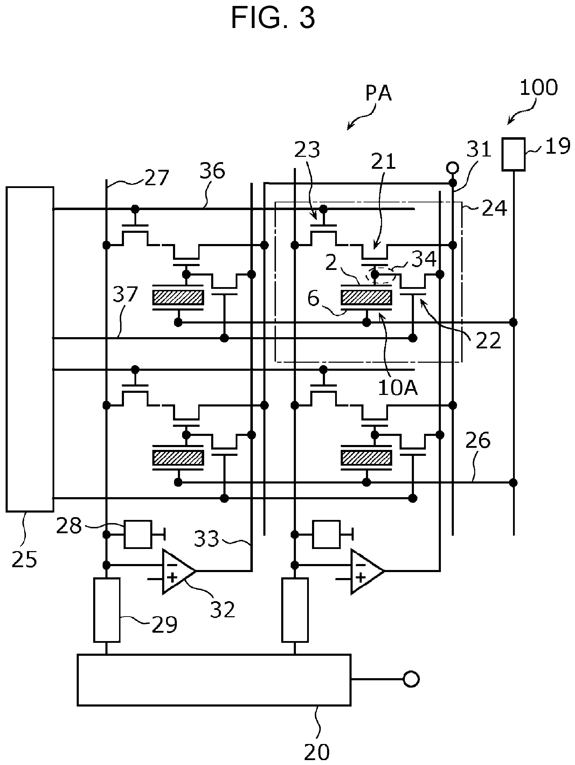

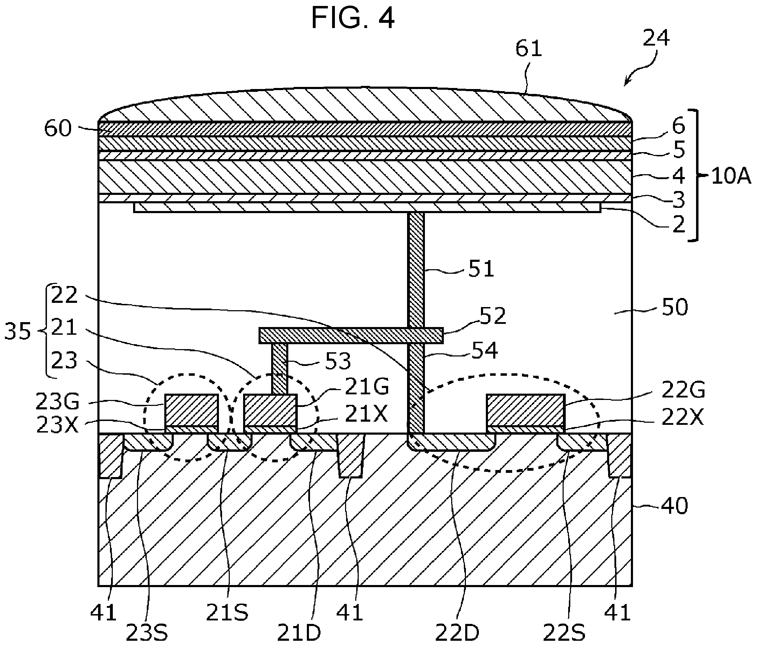

An imaging apparatus according to the present embodiment will now be described with reference to Figs. 3 and 4. The imaging apparatus according to the present embodiment is, for example, an imaging apparatus of a charge read-out system.

Fig. 3 is a diagram showing an example of the circuit configuration of an imaging apparatus 100 according to the present embodiment. Fig. 4 is a schematic cross-sectional view illustrating an example of the device structure of a pixel 24 in the imaging apparatus 100 according to the present embodiment.

The imaging apparatus 100 according to the present embodiment includes a semiconductor substrate 40 as an example of the substrate and a pixel 24. The pixel 24 includes a charge detection circuit 35 provided to the semiconductor substrate 40, a photoelectric conversion portion 10A provided on the semiconductor substrate 40, and a charge storage node 34 electrically connected to the charge detection circuit 35 and the photoelectric conversion portion 10A. The photoelectric conversion portion 10A of the pixel 24 includes the above-described photoelectric conversion element 10. The charge storage node 34 accumulates the charge obtained in the photoelectric conversion portion 10A, and the charge detection circuit 35 detects the charge accumulated in the charge storage node 34. Incidentally, the charge detection circuit 35 provided to the semiconductor substrate 40 may be provided on the semiconductor substrate 40 or may be directly provided in the semiconductor substrate 40.

As shown in Fig. 3, the imaging apparatus 100 includes a plurality of pixels 24 and peripheral circuits. The imaging apparatus 100 is an organic image sensor that is realized by an integrated circuit of one chip and includes a pixel array PA including a plurality of pixels 24 arranged two-dimensionally.

The plurality of pixels 24 are arranged two-dimensionally on the semiconductor substrate 40, i.e., in the row and column directions to form a photosensitive area that is a pixel area. Fig. 3 shows an example of pixels 24 arranged in a matrix of 2 rows and 2 columns. Incidentally, in Fig. 3, for convenience of illustration, illustration of circuits (for example, a pixel electrode control circuit) for individually setting the sensitivity of the pixels 24 is omitted. The imaging apparatus 100 may be a line sensor. In such a case, a plurality of pixels 24 may be one-dimensionally arranged. In the present specification, the row and column directions are the directions in which the rows and columns extend, respectively. That is, in Fig. 3, the vertical direction on the paper is the column direction, and the horizontal direction is the row direction.

As shown in Figs. 3 and 4, each pixel 24 includes a charge storage node 34 electrically connected to the photoelectric conversion portion 10A and the charge detection circuit 35. The charge detection circuit 35 includes a amplification transistor 21, a reset transistor 22, and an address transistor 23.

The photoelectric conversion portion 10A includes a lower electrode 2 provided as a pixel electrode and an upper electrode 6 provided as a counter electrode. The photoelectric conversion portion 10A includes the above-described photoelectric conversion element 10. The upper electrode 6 is applied with a predetermined bias voltage from a voltage supply circuit (illustration thereof is omitted in Fig. 3) through a counter electrode signal line 26.

The lower electrode 2 is connected to the gate electrode 21G of the amplification transistor 21, and the signal charge collected by the lower electrode 2 is accumulated in the charge storage node 34 positioned between the lower electrode 2 and the gate electrode 21G of the amplification transistor 21. In the present embodiment, the signal charge is a hole, but the signal charge may be an electron. Specifically, holes are accumulated in the charge storage node 34 as the signal charge by applying a reverse bias voltage between the lower electrode 2 and the upper electrode 6. Incidentally, when electrons are accumulated as the signal charge, a forward bias voltage is applied between the lower electrode 2 and the upper electrode 6.

The signal charge accumulated in the charge storage node 34 is applied to the gate electrode 21G of the amplification transistor 21 as a voltage according to the amount of the signal charge. The amplification transistor 21 amplifies this voltage, and the address transistor 23 selectively reads out the voltage as a signal voltage. The reset transistor 22 is connected to the lower electrode 2 through the source/drain electrode thereof and resets the signal charge accumulated in the charge storage node 34. In other words, the reset transistor 22 resets the potentials of the gate electrode 21G of the amplification transistor 21 and the lower electrode 2.

In order to selectively perform the above-described operation in a plurality of pixels 24, the imaging apparatus 100 includes a power supply wiring line 31, a vertical signal line 27, an address signal line 36, and a reset signal line 37, and these lines are respectively connected to each pixel 24. Specifically, the power supply wiring line 31 is connected to the source/drain electrode of the amplification transistor 21, and the vertical signal line 27 is connected to the source/drain electrode of the address transistor 23. The address signal line 36 is connected to the gate electrode 23G of the address transistor 23. The reset signal line 37 is connected to the gate electrode 22G of the reset transistor 22.

The peripheral circuits include a voltage supply circuit 19, a vertical scanning circuit 25, a horizontal signal read-out circuit 20, a plurality of column signal processing circuits 29, a plurality of load circuits 28, and a plurality of differential amplifiers 32.

The voltage supply circuit 19 is electrically connected to the upper electrode 6 through the counter electrode signal line 26. The voltage supply circuit 19 supplies a voltage to the upper electrode 6 to give a potential difference between the upper electrode 6 and the lower electrode 2. The voltage supply circuit 19 supplies, for example, a first voltage during a first period such as an exposure period described later and supplies a second voltage different from the first voltage during a second period such as a non-exposure period.

The vertical scanning circuit 25 is connected to the address signal line 36 and the reset signal line 37, selects a plurality of pixels 24 in a row unit from those arranged in respective rows, and performs read-out of a signal voltage and reset of the potential of the lower electrode 2. The power supply wiring line 31 is a source follower power supply and supplies a predetermined power-supply voltage to each pixel 24. The horizontal signal read-out circuit 20 is electrically connected to the plurality of column signal processing circuits 29. The column signal processing circuits 29 are electrically connected to the pixels 24 arranged in respective columns through the vertical signal line 27 corresponding to each column. The load circuits 28 are electrically connected to corresponding vertical signal lines 27. The load circuit 28 and the amplification transistor 21 form a source follower circuit.

The plurality of differential amplifiers 32 are provided so as to correspond to the respective columns. The input terminal on the negative side of the differential amplifier 32 is connected to the corresponding vertical signal line 27. The output terminal of the differential amplifier 32 is connected to pixels 24 through a feedback line 33 corresponding to each column.

The vertical scanning circuit 25 applies a row selection signal for controlling ON and OFF of the address transistor 23 to the gate electrode 23G of the address transistor 23 by the address signal line 36. Consequently, the row that is the read-out target is scanned and selected. The signal voltage is read out from the pixels 24 in the selected row to the vertical signal line 27. In addition, the vertical scanning circuit 25 applies a reset signal for controlling ON and OFF of the reset transistor 22 to the gate electrode 22G of the reset transistor 22 through the reset signal line 37. Consequently, the row of the pixels 24 that are targets of the reset operation is selected. The vertical signal line 27 transmits the signal voltage read out from the pixels 24 selected by the vertical scanning circuit 25 to the column signal processing circuit 29.

The column signal processing circuit 29 performs, for example, noise suppressing signal processing represented by correlated double sampling and analog-digital conversion (AD conversion).

The horizontal signal read-out circuit 20 sequentially reads out signals from the plurality of column signal processing circuits 29 to a horizontal common signal line (not shown).

The differential amplifier 32 is connected to the drain electrode of the reset transistor 22 through the feedback line 33. Accordingly, the differential amplifier 32 receives the output value of the address transistor 23 at the negative terminal. The differential amplifier 32 performs feedback operation such that the gate potential of the amplification transistor 21 becomes a predetermined feedback voltage. On this occasion, the output voltage value of the differential amplifier 32 is 0 V or a positive voltage near 0 V. The feedback voltage means the output voltage of the differential amplifier 32.

As shown in Fig. 4, the pixel 24 includes a semiconductor substrate 40, a charge detection circuit 35, a photoelectric conversion portion 10A, and a charge storage node 34 (see Fig. 3).

The semiconductor substrate 40 may be, for example, an insulation substrate including a semiconductor layer provided on its surface on the side where a photosensitive area is formed and is, for example, a p-type silicon substrate. The semiconductor substrate 40 includes impurity regions 21D, 21S, 22D, 22S, and 23S and an element isolation region 41 for electrical isolating between pixels 24. The impurity regions 21D, 21S, 22D, 22S, and 23S are, for example, n-type regions. Here, the element isolation region 41 is provided between the impurity region 21D and the impurity region 22D. Consequently, the signal charge accumulated at the charge storage node 34 is suppressed from leaking. Incidentally, the element isolation region 41 is formed by, for example, implanting acceptor ions under predetermined injection conditions.

The impurity regions 21D, 21S, 22D, 22S, and 23S are, for example, diffusion regions formed in the semiconductor substrate 40. As shown in Fig. 4, the amplification transistor 21 includes an impurity region 21S, an impurity region 21D, and a gate electrode 21G. The impurity region 21S and the impurity region 21D function as, for example, a source region and a drain region, respectively, of the amplification transistor 21. A channel region of the amplification transistor 21 is formed between the impurity region 21S and the impurity region 21D.

Similarly, the address transistor 23 includes an impurity region 23S, an impurity region 21S, and a gate electrode 23G connected to the address signal line 36. In this example, the amplification transistor 21 and the address transistor 23 share the impurity region 21S and are thereby electrically connected to each other. The impurity region 23S functions as, for example, the source region of the address transistor 23. The impurity region 23S has connection with the vertical signal line 27 shown in Fig. 3.

The reset transistor 22 includes impurity regions 22D and 22S and a gate electrode 22G connected to the reset signal line 37. The impurity region 22S functions as, for example, the source region of the reset transistor 22. The impurity region 22S has connection with the reset signal line 37 shown in Fig. 3.

An interlayer insulation layer 50 is laminated on the semiconductor substrate 40 so as to cover the amplification transistor 21, the address transistor 23, and the reset transistor 22.

In the interlayer insulation layer 50, a wiring layer (not shown) can be arranged. The wiring layer is formed from, for example, a metal such as copper and can encompass, for example, wiring, such as the above-described vertical signal line 27, as a part thereof. The number of insulation layers in the interlayer insulation layer 50 and the number of layers included in the wiring layer arranged in the interlayer insulation layer 50 can be arbitrarily set.

In the interlayer insulation layer 50, a contact plug 54 connected to the impurity region 22D of the reset transistor 22, a contact plug 51 connected to the lower electrode 2, a contact plug 53 electrically connected to the gate electrode 21G of the amplification transistor 21, and a wiring 52 connecting the contact plug 51, the contact plug 54, and the contact plug 53 are arranged. Consequently, the impurity region 22D of the reset transistor 22 is electrically connected to the gate electrode 21G of the amplification transistor 21. In the configuration shown in Fig. 4, the contact plugs 51, 53, and 54, the wiring 52, the gate electrode 21G of the amplification transistor 21, and the impurity region 22D of the reset transistor 22 constitute at least a part of the charge storage node 34.

The charge detection circuit 35 detects the signal charge captured by the lower electrode 2 and outputs a signal voltage. The charge detection circuit 35 includes the amplification transistor 21, the reset transistor 22, and the address transistor 23 and is formed in the semiconductor substrate 40.

The amplification transistor 21 includes an impurity region 21D and an impurity region 21S that are formed in the semiconductor substrate 40 and function as a drain electrode and a source electrode, respectively, a gate insulation layer 21X formed on the semiconductor substrate 40, and a gate electrode 21G formed on the gate insulation layer 21X.

The reset transistor 22 includes an impurity region 22D and an impurity region 22S formed in the semiconductor substrate 40 and function as a drain electrode and a source electrode, respectively, a gate insulation layer 22X formed on the semiconductor substrate 40, and a gate electrode 22G formed on the gate insulation layer 22X.

The address transistor 23 includes impurity regions 21S and 23S formed in the semiconductor substrate 40 and function as a drain electrode and a source electrode, respectively, a gate insulation layer 23X formed on the semiconductor substrate 40, and a gate electrode 23G formed on the gate insulation layer 23X. The impurity region 21S is connected to the amplification transistor 21 and the address transistor 23 in series.

The above-described photoelectric conversion portion 10A is arranged on the interlayer insulation layer 50. In other words, in the present embodiment, a plurality of pixels 24 constituting a pixel array is formed on the semiconductor substrate 40. The plurality of pixels 24 two-dimensionally arranged on the semiconductor substrate 40 forms a photosensitive area. The distance between two adjacent pixels 24 (i.e., pixel pitch) may be, for example, about 2 µm.

The photoelectric conversion portion 10A has the structure of the above-described photoelectric conversion element 10.

A color filter 60 is formed in the upper part of the color photoelectric conversion portion 10A, and a microlens 61 is formed in the upper part of the color filter 60. The color filter 60 is formed, for example, as an on-chip color filter by patterning. As the color filter 60, for example, a photosensitive resin in which a dye or pigment is dispersed is used. The microlens 61 is formed as, for example, an on-chip microlens. As the microlens 61, for example, an ultraviolet sensitive material is used.

In manufacturing of the imaging apparatus 100, a general semiconductor manufacturing process can be used. In particular, when a silicon substrate is used as the semiconductor substrate 40, the imaging apparatus 100 can be manufactured by using various silicon semiconductor processes.

As an image sensor, such as an imaging apparatus, utilizing photoelectric conversion, for example, a CMOS (complementary metal oxide semiconductor) image sensor is widely used. In general, the CMOS image sensor adopts so-called rolling shutter, which performs exposure and read-out of signal charge sequentially row by row of the pixel array, as the signal read-out system. However, in the rolling shutter, the timing of start and end of exposure is different row by row. Accordingly, when a fast-moving object is imaged, a distorted image is obtained as the image of the object in some cases, and when a flash is used, a difference in brightness is caused in the image in some cases. From such a situation, there is a demand for a so-called global shutter function, which performs the start and end of exposure at the same timing in all pixels in the pixel array. The imaging apparatus 100 according to the present embodiment may be an imaging apparatus that is operated by such a global shutter system. The global shutter operation in the imaging apparatus 100 will now be described.

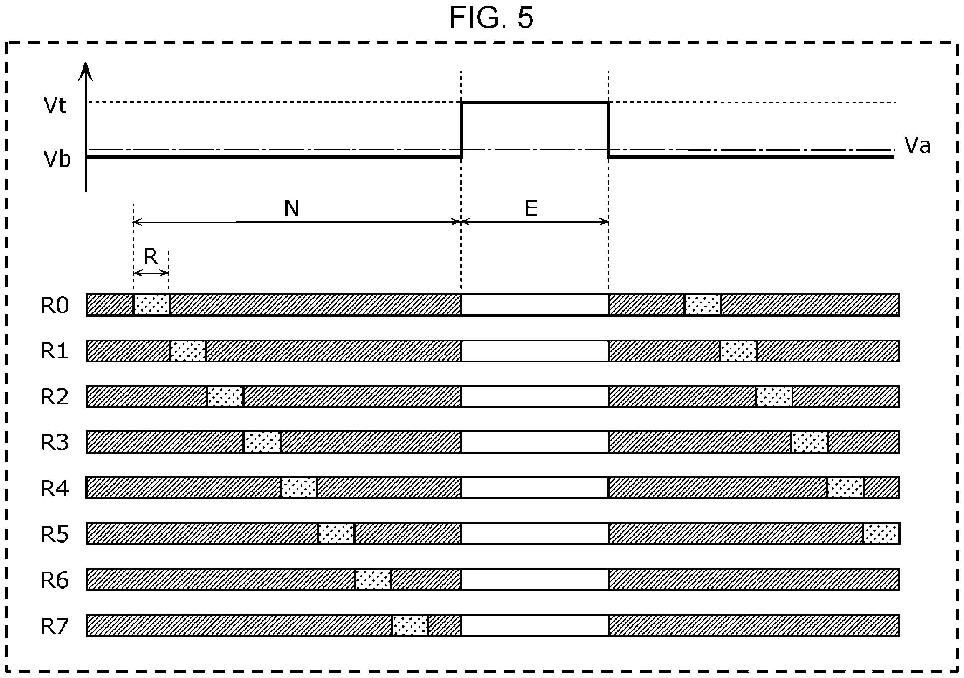

Fig. 5 is a timing chart for explaining a global shutter operation in the imaging apparatus 100.

Fig. 5 schematically shows the photoelectric conversion portion 10A, specifically, the temporal change in the magnitude of the bias voltage applied between the lower electrode 2 and the upper electrode 6 and the timing of operation in each row of the pixel array PA of the imaging apparatus 100. For clarity, only a change in bias voltage and timing of exposure and signal read-out of each row in the pixel array PA indicated by from R0 to R7 are shown. Here, a case of using holes as the signal charge will be described.

Fig. 5 shows the exposure period E, the non-exposure period N, and the signal read-out R in the imaging apparatus 100. In the present specification, the exposure period E is the period for accumulating the charge generated by photoelectric conversion, specifically holes, in the charge storage node 34. That is, the "exposure period" may be called as "charge accumulation period".

In the present specification, the non-exposure period N is the period other than the exposure period E during operation of the imaging apparatus 100. The non-exposure period N may be the period during which incident of light on the photoelectric conversion portion 10A is blocked or may be the period during which charge is not substantially accumulated in the charge storage node 34 although the photoelectric conversion portion 10A is irradiated with light.

As shown in Fig. 5, in the imaging apparatus 100, for example, during the non-exposure period N, which is an example of the second period, a voltage Vb for migration of the holes generated in the photoelectric conversion layer 4 to the charge storage node 34 is applied to the upper electrode 6. During the exposure period E, which is an example of the first period, a voltage Vt that can prevent the migration of charge from the photoelectric conversion layer 4 to the charge storage node 34 is applied to the upper electrode 6. That is, the voltage supply circuit 19 supplies a voltage to the upper electrode 6 such that the photoelectric conversion efficiency of the pixel 24, specifically, the photoelectric conversion portion 10A, is different between the exposure period E and the non-exposure period N. The lower electrode 2 is, for example, applied with a voltage Va during both the non-exposure period N and exposure period E.

For example, during the exposure period E, the voltage supply circuit 19 applies a voltage Vt, which is higher than the voltage Va, to the upper electrode 6 as the first voltage. That is, the holes generated in the photoelectric conversion layer 4 migrate to the charge storage node 34 by applying a reverse bias voltage to the photoelectric conversion portion 10A. In addition, for example, during the non-exposure period N, the voltage supply circuit 19 applies a voltage Vb, which is equal to or slightly lower than the voltage Va, to the upper electrode 6 as the second voltage. That is, the charge is prevented from migrating from the photoelectric conversion layer 4 to the charge storage node 34 by applying a forward bias voltage with an appropriate magnitude to the photoelectric conversion portion 10A. Consequently, charge is not substantially accumulated during the non-exposure period N regardless of the amount of light incident on the photoelectric conversion portion 10A.

As shown in Fig. 5, during the non-exposure period N, the signal read-out R of the pixels 24 in each of the rows from R0 to R7 is sequentially performed. The timings of the start and end of the exposure period E are the same in the pixels 24 in all rows from R0 to R7. That is, the imaging apparatus 100 achieves global shutter while performing signal read-out of the pixels 24 in each row sequentially.

In such global shutter operation, the dark current is required to be decreased during both periods of the exposure period E and the non-exposure period N in order to perform good imaging. In the global shutter operation, for example, a reverse bias voltage is applied to the photoelectric conversion portion 10A during the exposure period E, and a forward bias voltage is applied during the non-exposure period N. Since the current flow direction when a reverse bias voltage is applied is opposite to that when a forward bias voltage is applied, in the imaging apparatus performing global shutter operation, the first charge blocking layer 5 is required to block the migration of charge of both polarities, electrons and holes. Since the photoelectric conversion portion 10A of the imaging apparatus 100 according to the present embodiment includes the above-described photoelectric conversion element 10, the generation of an intermediate level in the first charge blocking layer 5 is prevented regardless of whether a forward bias voltage or a reverse bias voltage is applied to the photoelectric conversion portion 10A, and thereby the dark current can be decreased. Accordingly, the imaging apparatus 100 includes the photoelectric conversion element 10 and thereby can perform good imaging even when global shutter operation is performed.

As described above, according to the present embodiment, a photoelectric conversion element and an imaging apparatus that can each decrease the dark current can be obtained.

### EXAMPLES

The photoelectric conversion element according to the present disclosure will now be specifically described by examples, but the present disclosure is not limited to the following examples only. In detail, a photoelectric conversion element according to an embodiment of the present disclosure and a photoelectric conversion element for characteristics comparison were produced, and dark currents were measured.

### (Synthesis and preparation of material)

As a material used for the photoelectric conversion layer 4, (OPr)₈Si(O-4-CNPh)₂Nc represented by the following structural formula (1) was synthesized by the following method.

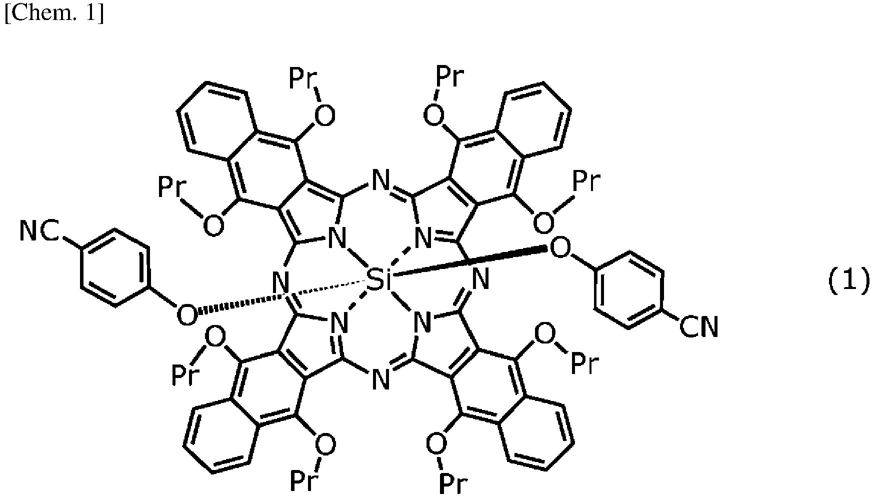

### (1) Synthesis of (OPr)₈Si(OH)₂Nc (Compound (A-2))

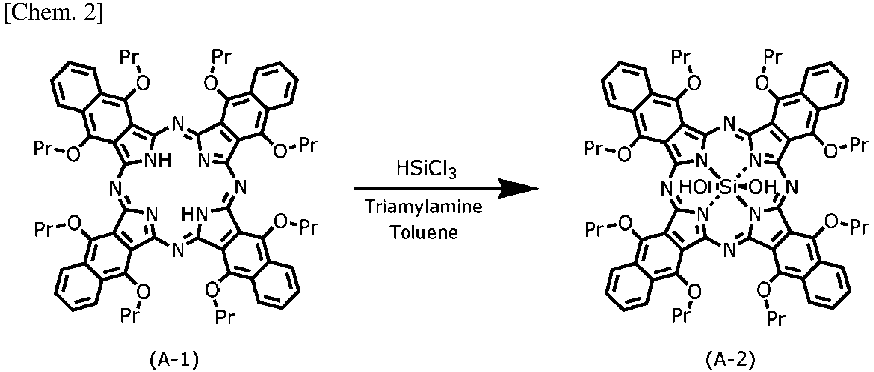

(OPr)₈H₂Nc (Compound (A-1), 50 mg), triamylamine (5 mL), and dehydrated toluene (25 mL) were put in a 50-mL reaction container substituted with argon, and HSiCl₃ (0.5 mL) was further added thereto, followed by heating and stirring at 90°C for 24 hours.

The reaction solution was cooled to room temperature, and distilled water (20 mL) was added to the reaction solution, followed by stirring for 1 hour. The reaction solution was extracted with toluene (60 mL) four times. The extracted organic layer was washed with distilled water, and the organic layer was then concentrated to obtain 48 mg of a crude product. The resulting crude product was purified by a neutral alumina column to obtain the target compound (OPr)₈Si(OH)₂Nc (Compound (A-2)) as a brown solid. The amount of the target compound was 25 mg, and the yield was 49%.

### (2) Synthesis of (OPr)₈Si(O-4-CNPh)₂Nc (Compound (A-3))

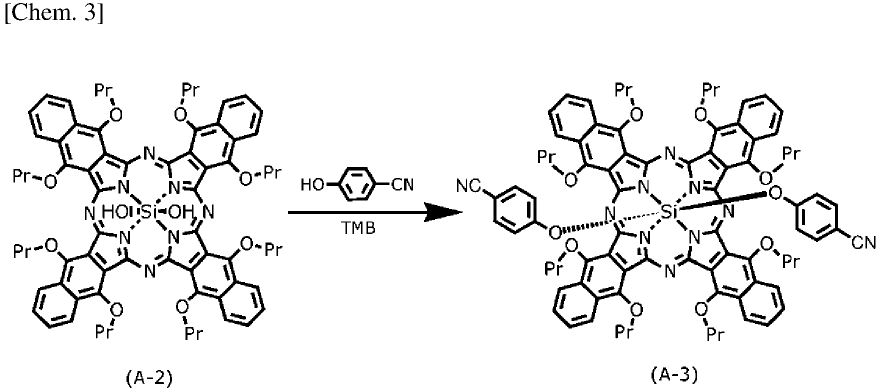

Subsequently, (OPr)₈Si(OH)₂Nc (Compound (A-2), 0.75 g) synthesized in the step (1) and 4-cyanophenol (0.91 g) were put in a 200-mL reaction container substituted with argon and were dissolved in 1,2,4-trimethylbenzene (TMB, 30 mL), followed by heating and refluxing at 180°C for 3 hours. The reaction solution was cooled to room temperature, heptane (50 mL) was then added to the reaction solution to precipitate a solid component, and the precipitated solid component was collected by filtration. The resulting solid component was purified by silica gel column chromatography (eluent of toluene : ethyl acetate = 1 : 1), and the resulting purified product was further re-precipitated by heptane. The resulting precipitate was dried under reduced pressure at 100°C for 3 hours to obtain the target compound ((OPr)₈Si(O-4-CNPh)₂Nc (Compound (A-3)). The amount of the target compound was 557 mg, and the yield was 74%.

The resulting compound was identified by ¹H NMR, MALDI-TOF-MS. The results are shown below.

¹H NMR (400 MHz, C₆D₆): δ (ppm) = 9.11 (8H), 7.58 (8H), 5.58 (4H), 5.06 (16H), 3.70 (4H), 2.24 (16H), 1.11 (24H)

MALDI-TOF-MS actual value: m/z = 1441.82 (M⁺)

The chemical formula of the target compound is C₈₆H₈₀N₁₀O₁₀Si, and the exact mass is 1441.82.

It was confirmed from the results above that the target compound was obtained by the above-described synthesis procedure.

The materials other than ((OPr)₈Si(O-4-CNPh)₂Nc were prepared by purchasing commercially available products.

### (Production of photoelectric conversion element)

Photoelectric conversion elements in Examples and Comparative Examples were produced.

The photoelectric conversion elements were all produced without being exposed to the atmosphere.

### [EXAMPLE 1]

A glass substrate provided with an ITO film having a thickness of 150 nm was used as a support substrate. The ITO film was used as a lower electrode 2, and a toluene solution of 10 mg/mL of VNPB (N4,N4'-di(naphthalen-1-yl)-N4,N4'-bis(4-vinylphenyl)biphenyl-4,4'-diamine) was applied as the material for a second charge blocking layer 3 onto the lower electrode 2 by spin coating to form a film of the material for the second charge blocking layer 3. The support substrate after the film formation was heated using a hot plate at 200°C for 50 minutes to crosslink and insolubilize the VNPB to form a second charge blocking layer. Incidentally, the thickness of the second charge blocking layer 3 obtained on this occasion was about 30 nm.

Subsequently, a chlorobenzene mixture solution of 30 mg/mL of a mixture of ((OPr)₈Si(O-4-CNPh)₂Nc as a donor organic semiconductor material 4A and PCBM as an acceptor semiconductor material mixed at a weight ratio of 1 : 9 was applied by a spin coating method to form a photoelectric conversion layer 4. Incidentally, the thickness of the photoelectric conversion layer 4 obtained on this occasion was about 150 nm.

Then, 9,9'-[1,1'-biphenyl]-4,4'-diylbis[3,6-bis(1,1-dimethyl ethyl)]-9H-carbazole as a first material of a first charge blocking layer 5 and ClAlPc (chloroaluminum phthalocyanine) as a second material of the first charge blocking layer 5 were co-deposited at a weight ratio of 1 : 2 on the photoelectric conversion layer 4 through a metal shadow mask by a vacuum vapor deposition method to form a first charge blocking layer 5. Incidentally, the thickness of the first charge blocking layer 5 obtained on this occasion was about 30 nm.

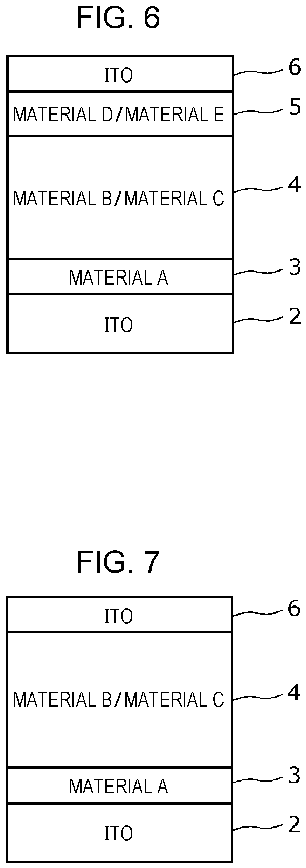

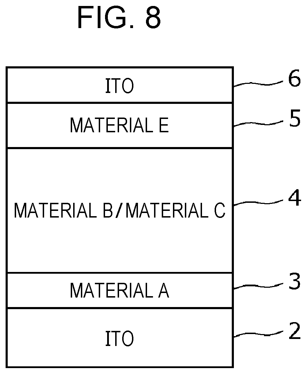

Subsequently, an ITO film was formed with a thickness of 30 nm as an upper electrode 6 on the first charge blocking layer 5 by a sputtering method, and an Al₂O₃ film was then further formed as a sealing film on the upper electrode 6 by an atomic layer deposition method to obtain a photoelectric conversion element. Fig. 6 shows the schematic configuration of the photoelectric conversion element in Example 1. In Fig. 6, the material A is VNPB, the material B is ((OPr)₈Si(O-4-CNPh)₂Nc, the material C is PCBM, the material D is 9,9'-[1,1'-biphenyl]-4,4'-diylbis[3,6-bis(1,1-dimethyl ethyl)]-9H-carbazole, and the material E is ClAlPc. These materials are the same in Figs. 7 and 8 described later.

### [EXAMPLE 2]

A photoelectric conversion element was obtained by performing the same process as in Example 1 except that 9,9'-[1,1'-biphenyl]-4,4'-diylbis[3,6-bis(1,1-dimethyl ethyl)]-9H-carbazole as the first material of the first charge blocking layer 5 and ClAlPc as the second material of the first charge blocking layer 5 were co-deposited at a weight ratio of 1 : 1. The schematic configuration of the photoelectric conversion element in Example 2 is also as shown in Fig. 6.

### [EXAMPLE 3]

A photoelectric conversion element was obtained by performing the same process as in Example 1 except that 9,9'-[1,1'-biphenyl]-4,4'-diylbis[3,6-bis(1,1-dimethyl ethyl)]-9H-carbazole as the first material of the first charge blocking layer 5 and ClAlPc as the second material of the first charge blocking layer 5 were co-deposited at a weight ratio of 2 : 1. The schematic configuration of the photoelectric conversion element in Example 3 is also as shown in Fig. 6.

### [COMPARATIVE EXAMPLE 1]

A photoelectric conversion element was obtained by performing the same process as in Example 1 except that the first charge blocking layer 5 was not formed. The schematic configuration of the photoelectric conversion element in Comparative Example 1 is shown in Fig. 7.

### [COMPARATIVE EXAMPLE 2]

A photoelectric conversion element was obtained by performing the same process as in Example 1 except that 9,9'-[1,1'-biphenyl]-4,4'-diylbis[3,6-bis(1,1-dimethyl ethyl)]-9H-carbazole as the first material was not used as the material of the first charge blocking layer 5 and ClAlPc as the second material only was deposited by a vacuum vapor deposition method. The schematic configuration of the photoelectric conversion element in Comparative Example 2 is shown in Fig. 8.

### (Measurement of ionization potential and electron affinity of material)

The ionization potential and electron affinity of each material used in Examples were measured.

In the measurement of ionization potential, samples were prepared by forming a film from each of the materials used in Examples on an ITO substrate. Subsequently, regarding the prepared samples, the numbers of photoelectrons when the energy of UV-irradiation was varied were measured using an atmosphere photoelectron spectrometer (AC-3, manufactured by Riken Keiki Co., Ltd.), and the energy position at which photoelectrons begin to be detected was defined as the ionization potential.

In the measurement of the electron affinity, first, samples were prepared by forming a film from each of the materials used in Examples on a quartz substrate. Secondly, regarding the prepared samples, the absorption spectra were measured using a spectrophotometer (U4100, manufactured by Hitachi High-Tech Corporation), and the optical band gaps were calculated from the results of absorption edges of the resulting absorption spectra. The electron affinity was estimated by subtracting the calculated optical band gap from the ionization potential obtained in the measurement of ionization potential.

Table 1 shows the ionization potential, electron affinity, and energy band gap, which is the difference between the ionization potential and the electron affinity, of each material used in Examples.

**[Table 1]**

| Layer | | Material | Ionization potential (eV) | Electron affinity (eV) | Energy band gap (eV) |
|---|---|---|---|---|---|
| Second charge blocking layer | | VNPB (Material A in Fig. 6) | 5.4 | 2.4 | 3.0 |
| Photoelectric conversion layer | Donor organic semiconductor material | (OPr)₈Si(O-4-CNPh)₂Nc (Material B in Fig. 6) | 5.2 | 4.0 | 1.2 |
| | Acceptor organic semiconductor material | PCBM (Material C in Fig. 6) | 6.2 | 4.3 | 1.9 |
| First charge blocking layer | First material | 9,9'-[1,1'-Biphenyl]-4,4'-diylbis[3,6-bis(1,1-dimethyl ethyl)]-9H-carbazole (Material D in Fig. 6) | 5.8 | 2.7 | 3.1 |
| | Second material | ClAlPc (Material E in Fig. 6) | 5.5 | 4.0 | 1.5 |

As shown in Table 1, in the photoelectric conversion elements in Examples, the first charge blocking layer 5 is made of a mixed material of 9,9'-[1,1'-biphenyl]-4,4'-diylbis[3,6-bis(1,1-dimethyl ethyl)]-9H-carbazole having an energy band gap of 3.1 eV as the first material and ClAlPc having an energy band gap of 1.5 eV as the second material. That is, the energy band gap of the second material is narrower than that of the first material.

The electron affinity of the first material is 2.7 eV, and the electron affinity of the second material is 4.0 eV. That is, the electron affinity of the first material is lower than that of the second material. The ionization potential of the first material is 5.8 eV, and the ionization potential of the second material is 5.5 eV. That is, the ionization potential of the first material is higher than that of the second material.

The electron affinity of the second material is 4.0 eV, and the electron affinity of the acceptor organic semiconductor material of the photoelectric conversion layer 4 is 4.3 eV. That is, the electron affinity of the second material is lower than that of the acceptor organic semiconductor material.

The ionization potential of the first material is 5.8 eV, and the ionization potential of the donor organic semiconductor material of the photoelectric conversion layer 4 is 5.2 eV. That is, the ionization potential of the first material is higher than that of the donor organic semiconductor material.

The ionization potential of the second material is 5.5 eV, and the ionization potential of the donor organic semiconductor material of the photoelectric conversion layer 4 is 5.2 eV. That is, the ionization potential of the second material is higher than that of the donor organic semiconductor material.

Furthermore, the photoelectric conversion element in the present embodiment includes a second charge blocking layer 3, the electron affinity of the second charge blocking layer 3 is 2.4 eV, and the electron affinity of the acceptor organic semiconductor material of the photoelectric conversion layer 4 is 4.3 eV. That is, the electron affinity of the second charge blocking layer 3 is lower than that of the acceptor organic semiconductor material. In addition, the ionization potential of the second charge blocking layer 3 is 5.4 eV, and the ionization potential of the donor organic semiconductor material of the photoelectric conversion layer 4 is 5.2 eV. That is, the ionization potential of the second charge blocking layer 3 is higher than that of the donor organic semiconductor material.

Incidentally, in the present examples, the ionization potential of the second material of the first charge blocking layer 5 was higher than that of the donor organic semiconductor material of the photoelectric conversion layer 4, but they may be the same.

### (Measurement of dark current)

Regarding the photoelectric conversion elements in Examples and Comparative Examples, the dark currents were measured. In the measurement, a semiconductor device parameter analyzer (B1500A, manufactured by Keysight Technologies) was used. Specifically, the bias voltage applied between a pair of electrodes of a photoelectric conversion element was varied, and the current-voltage characteristics in the dark were measured.

Incidentally, regarding the reverse bias and forward bias in the bias voltage, application of a negative voltage to the lower electrode 2 or of a positive voltage to the upper electrode 6 is defined as reverse bias, and application of a positive voltage to the lower electrode 2 or of a negative voltage to the upper electrode 6 is defined as forward bias.

Table 2 shows the results of measurement of the current density in the dark as the dark current when bias voltages of 10 V in reverse bias and of 2 V in forward bias were applied to a pair of electrodes.

**[Table 2]**

| | | Example 1 | Example 2 | Example 3 | Comparative Example 1 | Comparative Example 2 |
|---|---|---|---|---|---|---|
| First charge blocking layer | | Present | Present | Present | Absent | Present |
| First material: Second material | | 1 : 2 | 1 : 1 | 2 : 1 | - | Second material only |
| Dark current (mA/cm²) | Reverse bias voltage of 10 V | 1.80E-06 | 1.75E-06 | 2.37E-07 | 3.72E-04 | 1.76E-06 |
| | Forward bias voltage of 2 V | 3.60E-06 | 1.84E-06 | 2.11E-06 | 4.28E-04 | 2.10E-05 |

As shown in Table 2, compared to the photoelectric conversion element in Comparative Example 1 with a configuration not having the first charge blocking layer 5, the dark current was decreased by application of either a forward bias voltage or a reverse bias voltage in the photoelectric conversion element in Comparative Example 2 with a configuration including a first charge blocking layer 5 constituted of a single material of the second material only. However, in the case of a forward bias voltage, the dark current of the photoelectric conversion element in Comparative Example 2 was decreased by only one order of magnitude compared to the dark current of the photoelectric conversion element in Comparative Example 1, thus, the effect of decreasing the dark current is low. In contrast, the dark currents of the photoelectric conversion elements in Examples 1 to 3 each including a first charge blocking layer 5 constituted of a first material and a second material were decreased by two or more orders of magnitude in both forward and reverse bias voltages, compared to the dark current of the photoelectric conversion element in Comparative Example 1. Furthermore, in the first charge blocking layer, the dark current of the photoelectric conversion element in Example 3 in which the weight of the first material is larger than that of the second material was further decreased than those of the photoelectric conversion elements in Examples 1 and 2 and Comparative Example 2 with the reverse bias voltage.

As described above, it was confirmed that the photoelectric conversion element according to the present disclosure includes, as in the photoelectric conversion elements in Examples 1 to 3, a first charge blocking layer 5 made of a mixed material of a first material having a broad energy band gap and a second material having an energy band gap narrower than that of the first material, and thereby the effect of decreasing the dark current is more enhanced. In addition, regardless of whether a forward bias voltage or a reverse bias voltage is applied, the dark currents of the photoelectric conversion elements in Examples 1 to 3 are decreased. Accordingly, the photoelectric conversion elements in Examples 1 to 3 are useful also when used in an imaging apparatus that is operated by a global shutter system as described above.

Incidentally, in Examples above, 9,9'-[1,1'-biphenyl]-4,4'-diylbis[3,6-bis(1,1-dimethyl ethyl)]-9H-carbazole and ClAlPc were used as the first material and the second material, respectively, of the first charge blocking layer 5, but other materials may be used in the first charge blocking layer 5. Examples of the first material and second material in the present disclosure are shown in Table 3. Table 3 also collectively shows the values of the ionization potential, electron affinity, and energy band gap of each material measured by the same method as that described in the "Measurement of ionization potential and electron affinity of material" above.

**[Table 3]**

| | Material name | Ionization potential (eV) | Electron affinity (eV) | Energy band gap (eV) |
|---|---|---|---|---|
| First material | BCP | 6.4 | 2.9 | 3.5 |
| | TAZ | 6.3 | 2.7 | 3.6 |
| | CBP | 6.0 | 2.6 | 3.4 |
| Second material | (OPr)₈Si(O-4-CNPh)₂Nc | 5.2 | 4.0 | 1.2 |
| | DTDCTB | 5.6 | 4.1 | 1.5 |
| | SubPc | 5.6 | 3.7 | 1.9 |

As shown in Table 3, examples the first material include BCP (2,9-dimethyl-4,7-diphenyl-1,10-phenanthroline), TAZ (3-(biphenyl-4-yl)-5-(4-tertbutylphenyl)-4-phenyl-4H-1,2,4-triazole), and CBP (4,4'-bis[9-dicarbazolyl]-2,2'-biphenyl). The first material has an energy band gap of, for example, 3.0 eV or more. Examples of the second material include ((OPr)₈Si(O-4-CNPh)₂Nc, DTDCTB (2-[[7-[5-[bis(4-methylphenyl)amino]-2-thienyl]-2,1,3-benzothiadiazol-4-yl]methylene]propanedinitrile), and SubPc (subphthalocyanine). The second material has an energy band gap of, for example, 2.0 eV or less. Even if such first material and second material are used, an effect of decreasing the dark current is obtained.

Incidentally, the first material and the second material are not limited to these examples of materials, and may be semiconductor materials, such as organic semiconductor materials in an energy relationship as described above.

The photoelectric conversion element and imaging apparatus according to the present disclosure have been described above based on embodiments and examples, but the present disclosure is not limited to these embodiments and examples. As long as it does not apart from the gist of the present disclosure, the present disclosure also encompasses various modifications, which can be conceived by those skilled in the art, of the embodiments or examples and other aspects constructed by combining a part of components in the embodiments and examples.

For example, in the embodiments above, the first charge blocking layer 5 is positioned between the upper electrode 6 and the photoelectric conversion layer 4, but is not limited thereto. The first charge blocking layer 5 may be positioned between the lower electrode 2 and the photoelectric conversion layer 4, instead of the second charge blocking layer 3, and the second charge blocking layer 3 may be positioned between the upper electrode 6 and the photoelectric conversion layer 4. Even in this case, an effect of decreasing the dark current is obtained. In this case, the lower electrode 2 corresponds to the first electrode in the present disclosure, and the upper electrode 6 corresponds to the second electrode in the present disclosure.

### Industrial Applicability

The photoelectric conversion element and imaging apparatus according to the present disclosure are useful for, for example, an image sensor that is used in an imaging system represented by a digital camera.

### Reference Signs List

1 support substrate
2 lower electrode
3 second charge blocking layer
4 photoelectric conversion layer
4A donor organic semiconductor material
4B acceptor organic semiconductor material
5 first charge blocking layer
5A first material
5B second material
6 upper electrode
10 photoelectric conversion element
10A photoelectric conversion portion
19 voltage supply circuit
20 horizontal signal read-out circuit
21 amplification transistor
22 reset transistor
23 address transistor
21D, 21S, 22D, 22S, 23S impurity region
21G, 22G, 23G gate electrode
21X, 22X, 23X gate insulation layer
24 pixel
25 vertical scanning circuit
26 counter electrode signal line
27 vertical signal line
28 load circuit
29 column signal processing circuit
31 power supply wiring line
32 differential amplifier
33 feedback line
34 charge storage node
35 charge detection circuit
36 address signal line
37 reset signal line
40 semiconductor substrate
41 element isolation region
50 interlayer insulation layer
51, 53, 54 contact plug
52 wiring
60 color filter
61 microlens
100 imaging apparatus

## Claims

1. A photoelectric conversion element comprising:
a first electrode;
a second electrode;
a photoelectric conversion layer positioned between the first electrode and the second electrode and including a donor semiconductor material and an acceptor semiconductor material; and
a first charge blocking layer positioned between the first electrode and the photoelectric conversion layer, wherein
the first charge blocking layer includes a first material and a second material having an energy band gap narrower than an energy band gap of the first material,
an electron affinity of the first material is lower than an electron affinity of the second material, and
an ionization potential of the first material is higher than an ionization potential of the second material.

2. The photoelectric conversion element according to claim 1, wherein
the electron affinity of the second material is lower than an electron affinity of the acceptor semiconductor material.

3. The photoelectric conversion element according to claim 1 or 2, wherein
the ionization potential of the first material is higher than an ionization potential of the donor semiconductor material.

4. The photoelectric conversion element according to any one of claims 1 to 3, wherein
the ionization potential of the second material is equal to or higher than an ionization potential of the donor semiconductor material.

5. The photoelectric conversion element according to any one of claims 1 to 4, wherein
the energy band gap of the first material is 3.0 eV or more, and
the energy band gap of the second material is 2.0 eV or less.

6. The photoelectric conversion element according to any one of claims 1 to 5, wherein
a difference between the energy band gap of the first material and the energy band gap of the second material is 1.0 eV or more and 3.0 eV or less.

7. The photoelectric conversion element according to any one of claims 1 to 6, wherein
in the first charge blocking layer, a weight of the first material is greater than or equal to 30% and less than or equal to 70% of a total weight of the first material and the second material.

8. The photoelectric conversion element according to any one of claims 1 to 7, wherein
the donor semiconductor material is a donor organic semiconductor material, and
the acceptor semiconductor material is an acceptor organic semiconductor material.

9. The photoelectric conversion element according to any one of claims 1 to 8, further comprising:
a second charge blocking layer positioned between the second electrode and the photoelectric conversion layer.

10. The photoelectric conversion element according to claim 9, wherein
an electron affinity of the second charge blocking layer is lower than an electron affinity of the acceptor semiconductor material, and
an ionization potential of the second charge blocking layer is higher than an ionization potential of the donor semiconductor material.

11. An imaging apparatus comprising:
a substrate; and
a pixel including a charge detection circuit provided to the substrate, a photoelectric conversion portion provided on the substrate, and a charge storage node electrically connected to the charge detection circuit and the photoelectric conversion portion, wherein
the photoelectric conversion portion includes the photoelectric conversion element according to any one of claims 1 to 9.

12. The imaging apparatus according to claim 11, further comprising:
a voltage supply circuit electrically connected to the first electrode or the second electrode and giving a potential difference between the first electrode and the second electrode, wherein
the voltage supply circuit supplies a first voltage during a first period and a second voltage different from the first voltage during a second period to the first electrode or the second electrode connected to the voltage supply circuit.

13. The imaging apparatus according to claim 12, wherein
a photoelectric conversion efficiency of the pixel during the first period is different from a photoelectric conversion efficiency of the pixel during the second period.
